# EUROPÄISCHE PATENTSCHRIFT

(11) **EP 1 283 552 B1**
(45) Veröffentlichungstag und Bekanntmachung des Hinweises auf die Patenterteilung: **07.01.2009**
(21) Anmeldenummer: 02017213.6
(22) Anmeldetag: 31.07.2002
(51) Int. Cl.: H01L 41/08, H01L 41/22

(54) **Kristallelement für Piezosensoren**
Crystal element for piezoelectric sensors
Elément cristallin pour capteurs piézoélectriques

(30) Priorität: 02.08.2001 CH 14182001; 31.07.2002 CH 13452002
(43) Veröffentlichungstag der Anmeldung: 12.02.2003
(73) Patentinhaber: Kistler Holding AG, 8408 Winterthur (CH)
(72) Erfinder: Brechbühl, Stefan, 8570 Weinfelden (CH); Sommer, Roland, Dr., 8472 Seuzach (CH)

(56) Entgegenhaltungen:
- EP-A- 0 768 532
- EP-A- 0 932 044
- DE-A1- 3 830 174
- US-A- 4 494 409
- OHTSUCHI T ET AL: "Shock sensors using direct bonding of LiNbO3 crystals" ULTRASONICS SYMPOSIUM, 1996. PROCEEDINGS., 1996 IEEE SAN ANTONIO, TX, USA 3-6 NOV. 1996, NEW YORK, NY, USA,IEEE, US, Bd. 1, 3. November 1996 (1996-11-03), Seiten 331-334, XP010217894 ISBN: 0-7803-3615-1

## Beschreibung

Die Erfindung betrifft einen piezoelektrischen Kristall mit einer Kristallstruktur des Punktgruppe 32 mit Transversaleffekt.

Piezoelektrische Kristalle werden vielerorts in Sensoren verwendet zum Messen von Kräften, Drücken, Beschleunigungen, Dehnungen und Momenten. Dafür werden beispielsweise Kristalle mit Transversaleffekt in dünne Platten oder Stäbe geschnitten. Beim Einsatz in der Messtechnik werden diese dünnen Platten beispielweise einem Druck auf den kleinen Stirnflächen der Platte ausgesetzt, wodurch sich auf den beiden grossen Seitenflächen der Platten eine elektrische Ladung ansammelt. Durch das Aufbringen einer elektrisch leitenden Schicht auf die beiden Seitenflächen, die aber ihrerseits keinen elektrischen Kontakt zueinander aufweisen, wird diese Ladung mit der entsprechenden Vorrichtung im Sensor gemessen, wodurch Informationen über den Druck gewonnen und weitergeleitet werden können. Solche Sensoren sind hinreichend bekannt.

Entscheidend ist allerdings, dass der Kristall senkrecht und zentriert in der Achse des Sensors eingebaut wird. Eine leichte Kipplage resultiert in eine Fehlmessung oder in einen Bruch des Kristalls unter Einfluss der später auftretenden Kräfte. Ein Kontakt der Kristalls zum Rand des Sensors kann zu einem Kurzschluss oder zu einer Hysterese führen.

Da die Empfindlichkeit des Kristalls proportional zum Verhältnis der Ladungsabnahmefläche zur Druckfläche ist, sind diese herkömmlichen Kristallplatten sehr dünn. Dadurch wird die Handhabung, speziell das zentrierte und ausgerichtete Einsetzen in den Sensor, sehr schwierig und aufwändig. Häufig werden Zentrierhilfen mit in den Sensor eingebaut, welche die Kristalle an ihrer Position halten sollen. Die verschiedenen Materialien dieser Zentrierhilfen halten allerdings nicht sehr hohe Temperaturen aus. Dadurch wird das Einsatzgebiet des gesamten Sensors auf eine niedrigere Höchsttemperatur beschränkt.

Die vorliegende Erfindung stellt sich die Aufgabe, einen piezoelektrischen Kristall zum Messen von Kräften oder Drücken anzugeben, der sich ohne Aufwand zum Zentrieren und Ausrichten leicht im Sensor einbauen lässt, ohne den Einsatzbereich auf einen niedrigeren Temperaturbereich einzuschränken. Ausserdem soll ein Verfahren angegeben werden, durch das der Kristall auf rationelle Art auch in grossen Serien, günstig und vollautomatisch hergestellt werden kann.

Die Aufgabe wird erfindungsgemäss gelöst durch einen Kristall gemäss Anspruch 1, eine Anordnung von Kristallen gemäss Anspruch 6, einen Sensor gemäss Anspruch 7 und ein Verfahren gemäss Anspruch 8.

Die Erfindung wird unter Verwendung der folgenden Zeichnungen erläutert. Es zeigen
- Fig. 1: den Stand der Technik eines in einem Sensor eingebauten piezoelektrischen Kristalls
- Fig. 2: den Stand der Technik einer in einem Sensor eingebauten piezoelektrischen Kristallanordnung
- Fig. 3: eine erfindungsgemässe Ausführungsform eines piezoelektrischen Kristalls
- Fig. 4: einen erfindungemässen Kristall in eingebauter Lage
- Fig. 5: erfindungsgemässe Waferkristalle bei der Fertigung
- Fig. 6: eine weitere mögliche Ausführungsform eines erfindungsgemässen Kristalls
- Fig. 7: eine weitere mögliche Ausführungsform eines erfindungsgemässen Kristalls und eine erfindungsgemässe Anordnung solcher Kristalle

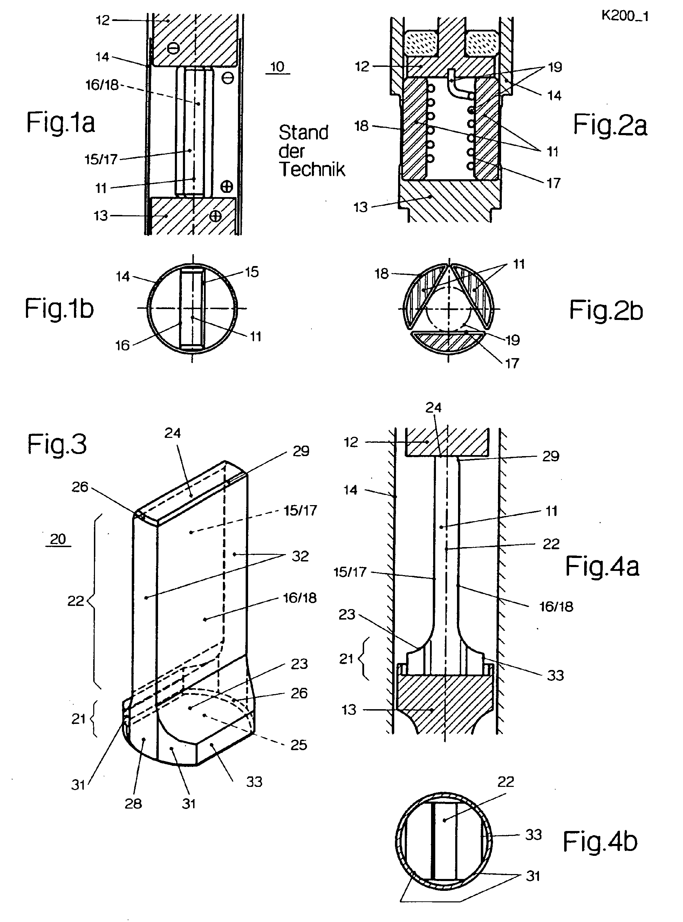

Fig.la zeigt in der Seitenansicht einen in eine Platte ausgebildeten piezoelektrischen Kristall 11 mit Transversaleffekt in einem Sensor 10 eingebaut, wie er aus dem Stand der Technik bekannt ist. Der Kristall 11 ist auf den Stirnflächen durch Haltevorrichtungen 12, 13 eingeklemmt, um ihn in der gewünschten Lage zu halten. Fig. 1b zeigt den Querschnitt eines auf diese Art im Sensor 10 montierten Kristalls 11 in einer Hülse 14. Die Ladung (+,-) wird von den beiden Seitenflächen 15,16 auf dafür angebrachten elektrisch leitenden Schichten weitergeleitet. Zu diesem Zweck verläuft die eine elektrisch leitende Schicht 17 zu einer oberen Haltevorrichtung 12, die andere Schicht 18 zu einer unteren Haltevorrichtung 13 auf der gegenüberliegenden Seite. Somit besitzen beide Haltevorrichtungen 17,18 entgegengesetzte elektrische Ladungen.

Fig. 2 zeigt eine weitere Ausführung des Standes der Technik. In dieser Ausführung werden beispielsweise drei identische Kristallstäbe 11, dessen Querschnitte Formen von Kreissegmenten aufweisen, gemäss Fig. 2b in einem Kreis angeordnet. Die Ladung an den äusseren Flächen der Kristalle 11 wird beispielsweise über eine Hülse 14 oder über eine Stirnfläche abgenommen. Der andere Pol an der Innenseite der Kristalle wird über eine elektrisch leitende Spirale 19 entnommen, wie dies in Fig. 2a gezeigt ist. Dabei dient die Spirale 19 als Zentrierhilfe der Kristalle 11, die von aussen wiederum an einer Hülse 14 festgehalten werden.

Fig. 3 zeigt einen erfindungsgemässen Kristall 20 mit Transversaleffekt. Dieser Kristall besteht aus einkristallinem Material, dessen Symmetrie der des piezoelektrischen d-Tensors der Punktgruppe 32 entspricht. Dieser Kristall 29 zeichnet sich aus durch einen Sockel 21, der an einem Ende einer Platte 22 angebracht ist. Dieser Sockel 21 ragt mindestens einseitig über die Dicke der Platte 22 hinaus. Der Übergang von der Platte 22 zum Sockel 21 kann erfindungsgemäss eine Rundung 23 aufweisen, um die Stabilität des Sockel-Platten Systems zu erhöhen. Andere Übergänge sind auch möglich. An der dem Sockel 21 gegenüber liegenden Stirnfläche der Platte 24 und am Sockelboden 25 können Fasen 26 angebracht sein, um ein Ausbrechen der Ränder zu verhindern.

Die beiden grösseren Seitenflächen der Platte 15,16 sind mit einer elektrisch leitenden Schicht 17,18 überzogen, die einen Ladungstransport ermöglicht. Eine Schicht 17 verläuft weiter bis auf das obere Ende der Kristallplatte. Die Schicht 18 auf der gegenüberliegenden Seite verläuft weiter über den Sockelrand 28 zum Sockelboden 25. Beim Einklemmen des Kristalls 20 durch geeignete Haltevorrichtungen 12,13 können wiederum entgegengesetzte Ladungen am Sockelboden 25 resp. An der Stirnfläche 24 entnommen werden. Dabei ist darauf zu achten, dass die elektrisch leitenden Schichten 17,18 voneinander elektrisch isoliert sind. Zu diesem Zweck ist eine Isolierfase 29 an der oberen Kante der Stirnfläche 24 angebracht, an der die elektrisch leitenden Schichten 17,18 unterbrochen sind.

Fig. 4a zeigt den erfindungsgemässen Kristall 20 in seiner im Sensor 10 eingebauten Lage. Die untere Haltevorrichtung 13 weist dazu eine Bohrung 30 auf, in die der Sockel 21 eingepasst werden kann. Die Bohrung 30 soll weniger tief sein als der Sockelrand 28. Dadurch wird gewährleistet, dass sie Seite der elektrisch leitenden Schicht 17, die nach oben weitergezogen ist, keinen elektrischen Kontakt zum Rand der Bohrung 30 aufweist. Die andere Seite der elektrisch leitenden Schicht 18 soll am Boden der Bohrung 30 einen guten elektrischen Kontakt gewährleisten.

Die Fig. 4b zeigt einen Querschnitt des montierten erfindungsgemässen Kristalls 20 im Bereich des Sockels 21. Dabei lässt sich erkennen, dass der Sockelrand 28 teilweise gerundete Konturen 31 aufweist. Dadurch wird das Einpassen des Kristalls 20 in die Bohrung 30 der Haltevorrichtung 13 gewährleistet. Die Rundung 31 kann im seitlichen Bereich des Kristalls durchgehend sein und sich über die Seitenflächen 32 der Kristallplatte fortsetzen. Die Rundung 31 im Sockel 21 sollte auf der Seite 33, die parallel zur Kristallplatte ist, nicht durchgehend sein. Durch das Anbringen der Rundung 31 würde sonst die elektrisch leitende Schicht 18 vollständig entfernt werden und müsste nachträglich wieder angebracht werden, um den Kontakt zur Bodenfläche des Sockels zu gewährleisten. Durch den Verzicht einer vollständigen Rundung 31 in diesem Bereich bleibt die elektrisch leitende Schicht 18 erhalten. Somit ist der Kontakt zur elektrischen Schicht des Sockelbodens 25 gewährleistet.

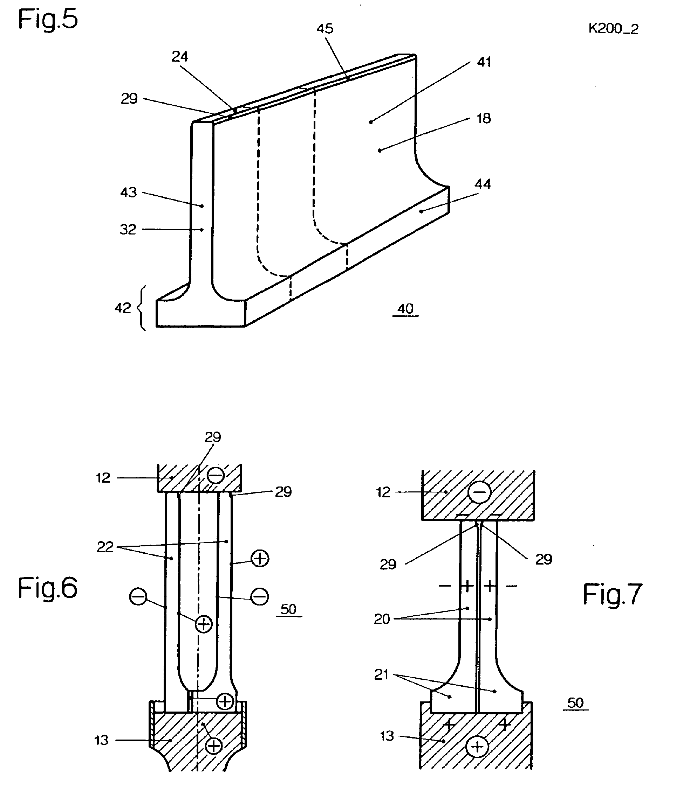

Das Verfahren zur serienmässigen Herstellung solcher erfindungsgemässen Kristalle wird an Fig. 5 dargelegt. Ein Kristallwafer 40, der beispielsweise die Form eines Quaders besitzt, wird in einer ersten Verfahrensstufe derart bearbeitet, dass eine Platte 41 in der gewünschten Dicke entsteht mit einer Sockelleiste 42, die entlang einer Kante der Platte 41 verläuft. Dabei ist darauf zu achten, dass der Übergang von der Platte 41 zur Sockelleiste 42 erfindungsgemäss eine Rundung 23 aufweist. In einem weiteren Verfahrensschritt wird der Kristallwafer 40 vollständig, abgesehen von den Stirnseiten 43, mit einer elektrisch leitenden Schicht überzogen. Danach wird die elektrisch leitende Schicht an zwei Stellen durchbrochen. Eine dieser Stellen ist der Rand der Sockelleiste 44 auf einer Seite. Die andere Stelle ist vorteilhafterweise entlang der oberen Kante und auf der anderen Seite des Kristallwafers 40. An dieser Stelle wird dazu vorteilhafterweise eine Isolierfase 45 angebracht. Durch diese Massnahme entstehen zwei von einander elektrisch getrennte elektrisch leitende Schichten 16,17.

In einem weiteren Verfahrensschritt wird der Kristallwafer 40 in zwei oder mehr kleinere Kristalle 20 getrennt, die alle einen Sockel 21 aufweisen und bereits über die elektrisch leitenden Schichten 16,17 verfügen. An jedem Sockel 21 dieser Kristalle 20 wird nun mindestens teilweise eine Rundung 31 angebracht. Diese Rundung kann entweder lediglich an den vier Ecken des Sockels 21 angebracht werden oder vollständig über die Seiten der Platte 22 erstreckt werden.

In einem weiteren Verfahrensschritt kann jeder Kristall 20 mit weiteren Fasen 26 am unteren Rand des Sockels sowie entlang der Kante der Stirnfläche 24 versehen werden, wobei die elektrisch leitende Schicht 17 an der Stirnfläche 24 nicht getrennt werden darf. Eine Fase 26 an dieser Stelle muss am Kristallwafer 40 angebracht werden, bevor die elektrisch leitende Schicht am Kristallwafer 40 angebracht wird.

Beim Einsetzen des Kristalls 20 ist der Kristall mit Seite des Sockels 21 in die Bohrung 30 der Haltevorrichtung 13 einzusetzen. Dabei ist darauf zu achten, dass die Bohrung 30 so gross ist, dass der Sockel 21 in der Bohrung 30 Spiel aufweist. Die Höhe des Sockelrands 28 soll dabei etwa doppelt so gross sein wir die Tiefe der Bohrung 30. Der Kristall 20 ist in der Bohrung 30 nicht geklemmt, doch reicht der Halt aus, um die zweite Haltevorrichtung 12 auf der gegenüberliegenden Seite anzubringen, ohne dass der Kristall 20 dezentriert werden könnte oder kippen könnte.

Die gesamte Höhe eines solchen erfindungsgemässen Kristalls 20 liegt zwischen 1 und 40 mm, vorzugsweise zwischen 2 und 10 mm. Die Sockelhöhe, einschliesslich der gerundeten Konturen 31 zur Kristallplatte, beträgt erfindungsgemäss 1/10 bis 1/3 der gesamten Höhe des Kristalls 20. Die hier beschriebenen Kristalle eignen sich zur Verwendung in der Messtechnik, namentlich zum Messen von Kräften, Drücken, Beschleunigungen, Momenten und Dehnungen.

Eine andere Ausgestaltung des Kristalls 20 ist in Fig. 6 dargestellt. Dieser Doppelkristall 50 besteht aus zwei Kristallplatten 22, die mit demselben Sockel 21 miteinander verbunden sind. Der Vorteil dieser Anordnung liegt in der doppelten Belastbarkeit des Kristalls 50 durch Druck resp. Kraft bei gleicher Sensitivität und Bauhöhe. Andere Ausführungen mit mehr als zwei Platten 22 sind auch möglich. Bei dieser oder ähnlichen Anordnungen ist darauf zu achten, dass jede Kristallplatte 22 beidseitig eine elektrisch leitende Schicht 17,18 aufweist, wobei beide Schichten 17,18 einer Platte 22 mit jeweils anderen Haltevorrichtungen 12,13 in elektrisch leitendem Kontakt stehen und von anderen, anders geladenen elektrisch leitenden Schichten 18,17 isoliert sind. Dazu sind die notwendigen Isolierflächen und -fasen 29 anzubringen. Bei Anordnungen von mehreren Platten können seitliche Kerben oder Bohrungen vorteilhaft sein, deren Oberfläche mit elektrisch leitenden Schichten 18 versehen ist, um die Ladung an den Sockelboden 25 zu leiten.

Eine andere Ausgestaltung des Kristalls 20 ist in Fig. 7 dargestellt. Diese Ausführung besteht aus zwei identischen Kristallen 29, die jeweils einen Sockel aufweisen, der nur einseitig über die Kristallplatte 22 herausragt. Die Seiten 15 der Kristalle, die keinen Sockel aufweisen, können somit aneinandergestellt werden. Da sie dieselbe Polarisierung aufweisen ist ein Kurzschluss bei einer Berührung ausgeschlossen. Die Herstellung dieses Kristall entspricht sinngemäss der oben beschriebenen Herstellung der Kristalle. Das Zusammenstellen zweier solcher Kristalle ergibt eine sehr ähnliche Konfiguration wie die eines Kristalls in der Figur 3. Der Unterschied besteht jedoch darin, dass bei gleichen geometrischen Verhältnissen dieselbe Kraft auf den Kristall resp. auf die Kristalle angewandt werden kann, die Empfindlichkeit der Ausgestaltung mit dem Doppelkristall 50 der Fig. 7 aber doppelt so hoch ist, da die Fläche der Ladungsabnehmer doppelt so gross ist. Bei doppelter Breite der Kristallplatten 22 verdoppelt sich demnach die Belastbarkeit bei gleichbleibender Empfindlichkeit. In Bezug auf die Selbstzentrierung ist dieses Anordnungsbeispiels des Doppelkristalls 50 der Fig. 7 gleich dem des Einfachkristalls der Fig. 3.

In all diesen Beispielen kann auf Zusatzmaterialien verzichtet werden, die eine Zentrierung erleichtern würden. Somit ist der Einsatzbereich des Sensors auch keinen weiteren Einschränkungen von Temperaturbereichen unterworfen.

### Liste der Bezeichnungen

- 10: Sensor (Stand der Technik)
- 11: Kristall
- 12: Haltevorrichtung (oben)
- 13: Haltevorrichtung (unten)
- 14: Hülse
- 15: Seite des Kristalls
- 16: Seite des Kristalls
- 17: elektrisch leitende Schicht (z.B. -)
- 18: elektrisch leitende Schicht (z.B. +)
- 19: elektrisch leitende Spirale
- 20: erfindungsgemässer Kristall
- 21: Sockel
- 22: Platte
- 23: Rundung
- 24: Stirnfläche
- 25: Sockelboden
- 26: Fase
- 28: Sockelrand
- 29: Isolierfase
- 30: Bohrung
- 31: gerundete Konturen
- 32: Seitenflächen der Kristallplatte
- 33: Seite des Sockels, parallel zur Kristallplatte
- 40: Kristallwafer
- 41: Platte
- 42: Sockelleiste
- 43: Stirnseiten
- 44: Rand der Sockelleiste
- 45: Isolierfase
- 50: Doppelkristall

## Patentansprüche

1. Piezoelektrischer Kristall (20) mit einer Kristallstruktur der Punktgruppe 32 mit Transversaleffekt zum Messen von Kräften oder Drücken, ausgebildet in mindestens eine flach ausgebildete Platte (22), eine Stirnfläche (24) und einen Boden (25) zum Aufbringen einer Last, sowie in zwei Seitenflächen (15, 16), an denen sich unter der beschriebenen Lasteinwirkung Ladung ansammelt, **dadurch gekennzeichnet, dass** der Kristall (20) ein einstückig a.usgebildeter Kristall ist und der Kristall ferner mindestens zu einem, zu der Platte (22) senkrecht stehenden Sockel (21) ausgebildet ist, wobei der Sockel (21) über die Dicke der Platte (22) herausragt.

2. Kristall gemäss Anspruch 1, **dadurch gekennzeichnet, dass** mindestens beide Seitenflächen der Platte (15,16) eine elektrisch leitenden Schicht (17,18) aufweisen.

3. Kristall gemäss Anspruch 2, **dadurch gekennzeichnet, dass** sich mindestens zwei elektrisch leitende Schichten (17,18) auf dem Kristall befinden, die von einander elektrisch isoliert sind.

4. Kristall gemäss Anspruch 3, **dadurch gekennzeichnet, dass** eine der Schichten (18) bis auf den Sockelboden (25), eine andere Schicht (17) bis auf die Stirnfläche (24) ausgestaltet ist.

5. Kristall gemäss Anspruch 1, **dadurch gekennzeichnet, dass** der Sockelrand (28) mindestens teilweise kreisrund ausgestaltet ist.

6. Anordnung von zwei identischen Kristallen gemäss einem der Ansprüche 1 bis 5, **dadurch gekennzeichnet, dass** der Sockel (21) genau einseitig über die Platte (22) herausragt und die beiden Kristalle an den Seiten ohne Sockel 15, die dieselbe Polarisierung aufweisen, aneinandergestellt werden.

7. Piezoelektrischer Sensor (10) zur Signalaufnahme von Kraft oder Druck mit mindestens einem darin enthaltenen piezoelektrischen Kristall (20) nach Anspruch 1.

8. Verfahren zur Herstellung von piezoelektrischen Kristallen (20) mit Transversaleffekt, **gekennzeichnet durch** das Bearbeiten eines Kristallwafers (40) auf eine gewünschten Plattendicke (41) unter Beibehaltung einer Sockelleiste (42), das Anbringen einer Beschichtung auf der Oberfläche mit einem elektrisch leitenden Material, das Anbringen von mindestens zwei Isolierfasen (45), die die elektrisch leitende Schicht in zwei voneinander elektrisch getrennte Schichten (17,18) teilt, und das ein- oder mehrfache Trennen des Kristallwafers (40) in kleinere Platten (22) mit Sockeln (21).

9. Verfahren gemäss Anspruch 8, **dadurch gekennzeichnet, dass** eine Isolierfase (29) einseitig auf der Sockelleiste (42) angebracht wird und eine weitere Isolierfase (29) diametral davon auf der Kante der Kristallwafers (40) angebracht wird.

10. Verfahren gemäss Anspruch 8 oder 9, **dadurch gekennzeichnet, dass** die Sockel (21) der entstandenen Kristalle mindestens teilweise mit gerundeten Konturen (31) versehen werden.

11. Verfahren gemäss Anspruch 8 oder 9, **dadurch gekennzeichnet, dass** die Kanten der Stirnfläche (24) und/oder am Sockelboden (25) mit Fasen (26) versehen werden.

## Claims

1. A piezoelectric crystal (20) having a crystal structure of point group 32 with transverse effect for measuring forces or pressures said crystal being formed into at least one flat plate (22), an end face (24), and a bottom (25) for the application of a load as well as into two lateral faces (15, 16) at which charge collects under the action of said load **characterized in that** the crystal (20) is an integrally formed crystal and **in that** further the crystal is formed at least into a base (21) which extends perpendicularly to the plate (22) wherein said base (21) projects beyond the thickness of the plate.

2. The crystal according to claim 1 **characterized in that** at least both lateral faces (15, 16) of the plate are each provided with an electrically conductive layer (17, 18).

3. The crystal according to claim 2 **characterized in that** there are at least two electrically conductive layers (17, 18) on the crystal which are electrically insulated from each other.

4. The crystal according to claim 3 **characterized in that** one of the layers (18) is formed up to the bottom (25) of the base, and another layer (17) is formed up to the end face (24).

5. The crystal according to claim 1 **characterized in that** the base edge (28) is at least partially formed in a circular shape.

6. An assembly of two identical crystals according to any of the claims 1 to 5 **characterized in that** the one side and **in that** the two crystals on the sides (15) without base which have the same polarization are placed abutting each other.

7. A piezoelectric sensor (10) for force or pressure signal absorption which have at least one piezoelectric crystal (20) according to claim 1 contained therein.

8. A method for the fabrication of piezoelectric crystals (20) with transverse effect **characterized in** processing of a crystal wafer (40) up to the desired plate thickness (41) while a base ledge (42) is maintained, applying of a coating of an electrically conductive material on the surface, applying of at least two insulating bevels (45) separating the electrically conductive layer into two layers (17, 18) which are electrically insulated from each other, and dividing of the crystal wafer (40) one ore more times into smaller plates (22) having bases (21).

9. The method according to claim 8 **characterized in that** an insulating bevel (29) is applied on one side on the base ledge (42) and another insulating bevel (29) is applied diametrically thereof on the edge of the crystal wafer (40).

10. The method according to claim 8 or 9 **characterized in that** the bases (21) of the resulting crystals are at least partially provided with rounded contours (31).

11. The method according to claim 8 or 9 **characterized in that** the edges of the end face (24) and/or at the base bottom (25) are provided with bevels (26).

## Revendications

1. Un cristal piézoélectrique (20) ayant une structure de cristal du groupe ponctuel 32 et un effet transverse adapté à la mesure de forces ou de pressions ledit cristal étant préparé sous forme d'au moins une plaque de forme plate (22), d'un front (24) et d'un fond (25) pour l'application d'une charge ainsi que de deux faces latérales (15, 16) sur lesquelles la charge électrique s'accumule sous l'action de ladite charge **caractérisé en ce que** le cristal (20) est un cristal formé par une pièce et **en ce que** le cristal est en outre formé sous forme d'au moins une embase (21) s'étendant perpendiculairement à la plaque (22) ladite embase (21) dépassant l'épaisseur de la plaque.

2. Le cristal selon la revendication 1 **caractérisé en ce qu'**au moins les deux faces latérales (15, 16) présentent une couche électriquement conductrice (17, 18).

3. Le cristal selon la revendication 2 **caractérisé en ce qu'**au moins deux couches électriquement conductrices (17, 18) se sont situées sur le cristal lesdites couches étant isolées électriquement l'une de l'autre.

4. Le cristal selon la revendication 3 **caractérisé en ce qu'**une de ces couches (18) est formée jusqu'au fond (25) de l'embase et une autre couche (17) est formée jusqu'au front (24).

5. Le cristal selon la revendication 1 **caractérisé en ce que** le bord (28) de l'embase est formé, au moins en partie, sous forme circulaire.

6. Un assemblage de deux cristaux identiques selon une des revendications 1 à 5 **caractérisé en ce que** l'embase (21) dépasse la plaque (22) exactement à une face et **en ce que** les deux cristaux aux faces sans embase (15) ayant la même polarisation sont placés l'un à coté de l'autre.

7. Un senseur piézoélectrique (10) adapté à l'absorption des signaux de force ou de pression en comportant au moins un cristal piézoélectrique (20) selon a revendication 1.

8. Un procédé pour la fabrication des cristaux piézoélectriques (20) ayant un effet transverse **caractérisé en ce qu'**on usine une plaquette de cristal (40) jusqu'à l'épaisseur de plaque désirée (41) en conservant une moulure de l'embase (42), on applique un revêtement d'un matériau électriquement conducteur sur la surface, on applique au moins deux biseaux isolants (45) séparant la couche électriquement conductrice en deux couches (17, 18) isolées électriquement l'une de l'autre et on divise la plaquette de cristal (40) une ou plusieurs fois en plaques plus petites (22) ayant des embases (21).

9. Le procédé selon la revendication 8 **caractérisé en ce qu'**on applique un biseau isolant (29) sur une face sur la moulure de l'embase (42) et on applique un autre biseau isolant (29) diamétralement opposé au premier sur le bord de la plaquette de cristal (40).

10. Le procédé selon la revendication 8 ou 9 **caractérisé en ce que** les embases (21) des cristaux obtenus sont, au moins partiellement, dotées de contours arrondis (31).

11. Le procédé selon la revendication 8 ou 9 **caractérisé en ce que** les bords du front (24) et/ou au fond de l'embase (25) sont dotés des biseaux (26).
